# FASCICULE DE BREVET EUROPEEN

(11) **EP 3 066 827 B1**
(45) Date de publication et mention de la délivrance du brevet: **27.12.2017**
(21) Numéro de dépôt: 14796005.8
(22) Date de dépôt: 30.10.2014
(51) Int. Cl.: H04N 5/378, H01L 21/768

(54) **CIRCUIT INTEGRE PRESENTANT PLUSIEURS BLOCS IDENTIQUES IDENTIFIES**
INTEGRIERTER SCHALTKREIS MIT MEHREREN IDENTIFIZIERTEN IDENTISCHEN BLÖCKEN
INTEGRATED CIRCUIT HAVING MULTIPLE IDENTIFIED IDENTICAL BLOCKS

(30) Priorité: 08.11.2013 FR 1360930
(43) Date de publication de la demande: 14.09.2016
(73) Titulaire: Trixell, 38430 Moirans (FR)
(72) Inventeur: CHARRIER, Laurent, 38430 Moirans (FR)
(74) Mandataire: Joubert, Cécile
(86) Numéro de dépôt international: PCT/EP2014/073383
(87) Numéro de publication internationale: WO 2015/067527

(56) Documents cités:
- US-A1- 2006 202 937
- US-A1- 2008 012 121
- US-A1- 2011 194 326
- US-B1- 7 928 762

## Description

### DOMAINE DE L'INVENTION

La présente invention concerne le domaine des circuits intégrés réalisés à partir d'un motif (« pattern » en terminologie anglo-saxonne) répété plusieurs fois en assurant un recouvrement pour que les lignes électriques puissent être connectées d'un motif à l'autre. Ces motifs sont dénommés « stitched patterns » en terminologie anglo-saxonne.

La présente invention trouve à s'appliquer dans tout type de circuit « stitched », tels que des imageurs, afficheurs ou détecteurs, ou des circuits mémoire.

### ETAT DE LA TECHNIQUE

Les circuits intégrés sont généralement réalisés à partir de plaquettes de silicium monocristallin, polycristallin ou de silicium amorphe à l'aide d'un procédé de photolithographie. Ce procédé utilise un masque qui est traversé par de la lumière destinée à insoler une couche de matériau photosensible (« photoresist » en terminologie anglo-saxonne) déposée sur la plaquette. A la suite de cette étape de lithographie, la plaquette est ensuite gravée pour éliminer du matériau, formant un motif tridimensionnel sur la surface du circuit. Le procédé insolation/gravure est renouvelé plusieurs fois pour générer les motifs des différentes couches constituant le circuit.

Certains circuits sont d'une dimension supérieure à la dimension du masque de l'appareil de photolithographie (« stepper » en terminologie anglo-saxonne). En effet les masques ou réticules utilisés dans les procédés de lithographies actuelle ont des dimensions de l'ordre de quelques centimètres de côté, tandis que certains circuits de type imageurs présentent une grande surface, par exemple supérieure ou égale à 100 cm².

Lorsque le circuit comprend des éléments identiques (typiquement une structure matricielle, par exemple des imageurs, afficheurs ou capteurs, ou des mémoires), une solution est de diviser le circuit en blocs identiques, qui sont réalisés à partir d'un masque unique décalé plusieurs fois selon une ou deux directions. On dénomme ce procédé « photolithographie composée », également appelé photocomposition ou « stitching » dans la littérature anglo-saxonne. Autrement dit, le circuit est formé par plusieurs expositions d'une plaquette semi-conductrice au travers d'un ou plusieurs masques. Chacune des expositions permet de réaliser une multitude d'éléments du circuit, par exemple plusieurs dizaines, centaines, voire milliers de pixels dans le cas de photocomposition de la zone matricielle d'un capteur d'image.
Les différents blocs sont aboutés de manière à assurer un recouvrement des connections électriques entre blocs.

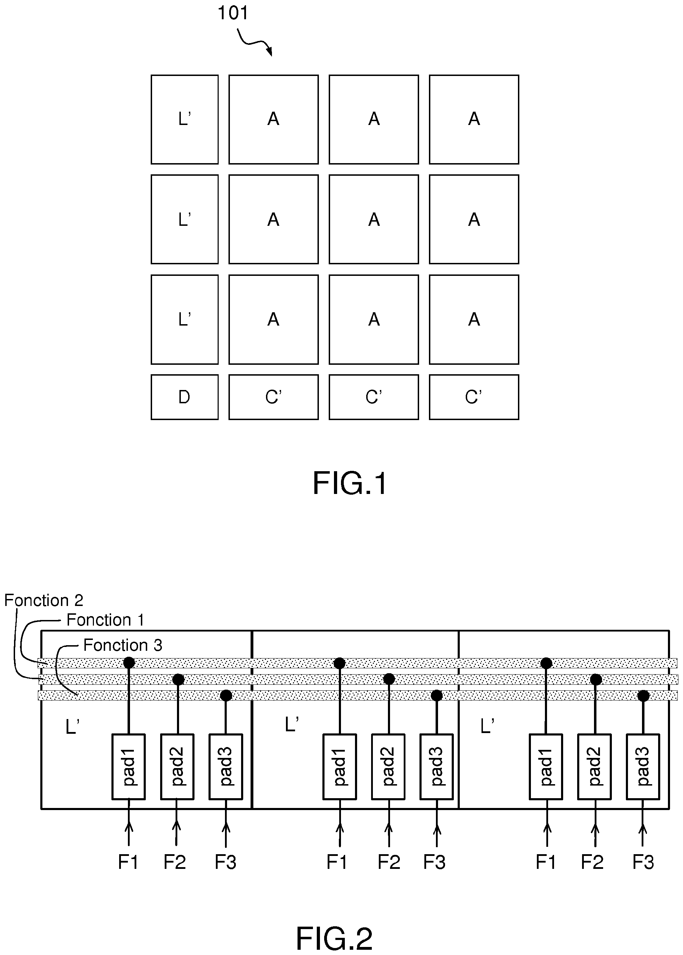

La figure 1 décrit un exemple de « stitched circuit » 101 de type matriciel comprenant des blocs A, L' et C' correspondant chacun à un motif répété plusieurs fois. Sur la figure 1 les blocs sont représentés séparés pour plus de clarté, mais dans la réalité ils se recouvrent pour assurer les connexions électriques. Un circuit matriciel 101 est par exemple un afficheur (tel un écran LCD), un détecteur (tel un détecteur de rayonnement X) ou un circuit mémoire (tel un circuit de mémoires CMOS flash).
Les blocs A sont composés de lignes, de colonnes et de pixels situés à l'intersection des lignes et des colonnes, et constituent la matrice proprement dite. Par exemple un bloc A peut regrouper de 10 x 10 à 100 x 100 pixels, la matrice complète pouvant comprendre plusieurs milliers de lignes et de colonnes.
Les blocs L' et C' comprennent les circuits d'adressage des lignes et des colonnes couramment dénommés « drivers » en terminologie anglo-saxonne. Ces blocs sont situés en périphérie de la matrice sur deux côtés perpendiculaires. Par exemple les blocs L' comprennent des drivers de lignes et les blocs C' des drivers de colonnes. Un bloc, L' ou C', peut comprendre une pluralité de drivers, chaque driver pilotant une pluralité de lignes ou de colonnes. Un driver ligne est configuré pour traiter les signaux électriques de commande d'une pluralité de lignes lors de l'adressage du circuit matriciel 101, ces signaux étant des signaux à injecter dans les lignes ou provenant des lignes et à récupérer pour être traiter, en fonction du type de circuit matriciel, de même pour les drivers colonne. Le bloc D est un coin sans fonction particulière, physiquement rectangulaire.

Ainsi le circuit matriciel de la figure 1 est composé de 3 x 3 blocs A, 3 blocs L' adressant par exemple les lignes et 3 blocs C' adressant par exemple les colonnes.

Les blocs A, L' et C' sont identiques entre eux par nature, du fait qu'ils ont été réalisés à partir d'un même motif, et ne peuvent donc pas être distingué les uns des autres. Pour certaines applications, il peut être intéressant d'identifier les différents blocs entre eux.

Une première solution simple consiste à utiliser un plot de connexion supplémentaire pour distinguer les blocs les uns des autres. Mais cette solution alourdi la connectique, déjà très dense dans les circuits matriciels comprenant un grand nombre de pixels.

A l'échelle de l'identification d'un pixel, le brevet US7928762 décrit un circuit d'identification pour chaque pixel d'une même colonne, le circuit comprenant un additionneur qui s'incrémente au fur et mesure que le rang du pixel augmente dans la colonne. Ce circuit est basé sur un composant actif, ce qui présente l'inconvénient d'avoir à l'alimenter.

En outre, les circuits de commande de lignes et de colonnes reçoivent certains signaux nécessaires à leur pilotage, dénommés fonctions, via des plots de connexion situés en périphérie de la matrice. Des fonctions génériques pour tous les circuits sont par exemple une mise en route du circuit (CHIP SELECT), un mode faible consommation (POWER DOWN), la remise à zéro d'une partie numérique (RESET), une fonction zoom. Ces plots sont aptes à relier les circuits de commandes de lignes et de colonnes à des circuits externes.

Ces fonctions sont génériques et utilisées par tous les drivers des blocs identiques (L' ou C').

La technique de masquage, identique de bloc à bloc, impose la répétition des plots de connexion pour chaque bloc. Ainsi pour distribuer une fonction 1 F1 sur un bus dédié parcourant l'ensemble des blocs identiques, il est nécessaire d'injecter cette fonction par un plot de connexion pad1 par bloc. Selon l'état de la technique, on a donc, par bloc, un pad par fonction, tel qu'illustré figure 2 pour 3 blocs identiques L' et 3 fonctions, fonction 1 F1, fonction 2 F2 et fonction 3 F3, respectivement distribuées à partir des plots de connexion pad1, pad2 et pad3. L'inconvénient est que cette méthode nécessite un grand nombre de plots.

Le but de l'invention est de remédier aux inconvénients précités, en proposant un circuit d'identification de bloc purement passif et réalisant un routage des fonctions décrites ci-dessus sur les bus associés avec un nombre réduit de plots de connexion.

### DESCRIPTION DE L'INVENTION

D'autres caractéristiques, buts et avantages de la présente invention apparaîtront à la lecture de la description détaillée qui va suivre et en regard des dessins annexés donnés à titre d'exemples non limitatifs et sur lesquels :
- la figure 1 déjà citée décrit un exemple de circuit « stitched » de type matriciel,
- la figure 2 déjà citée illustre une architecture de distribution de fonctions génériques selon l'état de la technique utilisant chacune un plot de connexion,
- la figure 3 illustre un circuit intégré 10 selon l'invention,
- la figure 4 illustre un mode de fonctionnement du circuit d'identification Ij d'un bloc Bj,
- la figure 5 illustre un circuit intégré selon l'invention comprenant un circuit de lecture Rj associé à chaque circuit d'identification Ij d'un bloc Bj,
- la figure 6 décrit un mode de réalisation dans lequel le circuit d'identification est associé à des blocs identiques de type B tel que décrit sur la figure 1, comprenant au moins un circuit de commande ligne,
- la figure 7 décrit un autre mode de réalisation dans lequel le circuit d'identification est associé à des blocs identiques de type C tel que décrit sur la figure 1, comprenant au moins un circuit de commande colonne,
- la figure 8 illustre la topologie d'un circuit intégré selon l'invention réalisant une fonction de routage,
- la figure 9 illustre un exemple de fonctionnement du circuit intégré selon l'invention,
- la figure 10 schématise l'architecture de distribution de fonctions selon l'invention,
- la figure 11 illustre une variante d'un circuit intégré selon l'invention,
- la figure 12 illustre une autre variante d'un circuit intégré selon l'invention,
- la figure 13 schématise 4 pixels de type 3T d'un capteur d'image,
- la figure 14 illustre un capteur d'image selon l'invention
- la figure 15 illustre un capteur d'image selon l'état de la technique.

### DESCRIPTION DETAILLEE DE L'INVENTION

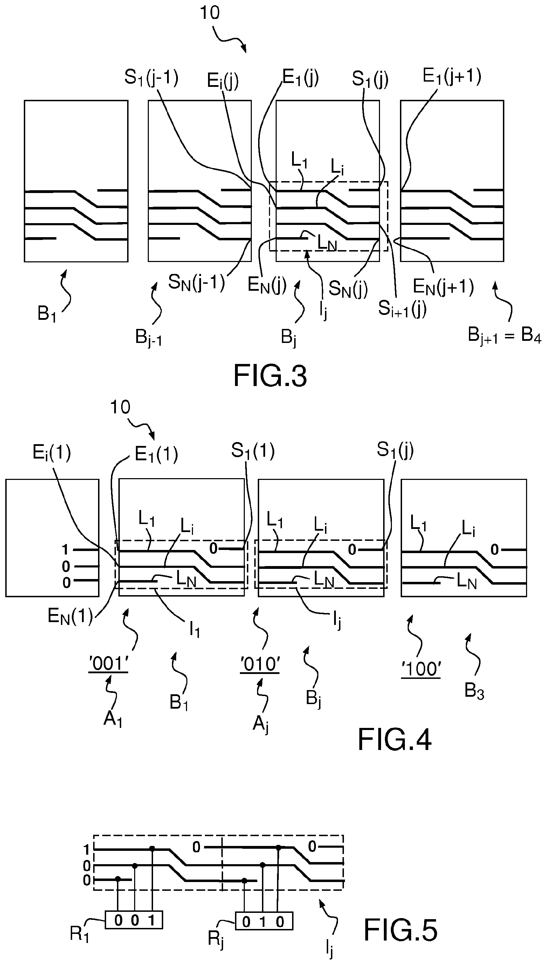

La figure 3 illustre un circuit intégré 10 permettant de comprendre l'invention.. Le circuit 10 comprend une pluralité de N blocs identiques adjacents B indicés par un indice j. Un bloc courant Bj est relié électriquement à un bloc précédent Bj-1 et à un bloc suivant Bj+1. Les blocs sont schématisés séparés sur la figure 3 pour la clarté du schéma, mais sont après masquage recouvrant pour permettre la continuité des lignes sur le circuit intégré.

Chaque bloc comprend un circuit d'identification Ij destiné, selon un premier aspect de l'invention, à distinguer les blocs identiques B les uns des autres. Le circuit d'identification Ij comprend N entrées ordonnées indicées i Ei(j), connectées aux N sorties du bloc précédent Bj-1 de même indice, ce qui signifie que l'entré Ei(j) est connectée électriquement à la sortie Si(j-1) par recouvrement des blocs. Il comprend également N sorties ordonnées indicées i Si(j), connectées aux N entrées du bloc suivant Bj+1 de même indice, ce qui signifie que la sorite Si(j) est connectée électriquement à l'entrée Ei(j+1) par recouvrement des blocs.

Il y a continuité électrique entre les entrées du bloc Bj et les sorties du bloc Bj-1 de même indice, et entre les sorties du bloc Bj et les entrées du bloc Bj+1 de même indice.

Chaque entrée i, Ei(j), pour i ≠N, du bloc courant Bj est reliée par une ligne de routage indicée i Li à la sortie i+1, Si+1 (j), du bloc courant. Une dernière entrée N, EN(j), du bloc courant Bj n'est reliée à aucune sortie du bloc courant, et une première sortie 1, S1(j) du bloc courant Bj n'est reliée à aucune entrée du bloc courant.

On entend par ligne de routage un conducteur électrique. La topologie du circuit d'identification décrit ci-dessus est identique pour tous les blocs, et les lignes de routage, dessinées sur le motif de masque, se décalent donc d'un cran à chaque bloc.
La figure 3 schématise la topologie du circuit d'identification pour N=4, mais le principe est bien entendu généralisable à N quelconque. Pour N blocs, on a N lignes de routage L1, ... Li, ... LN par bloc, comptées à partir de l'entrée d'un bloc.

Le circuit d'identification est utilisé, en combinaison avec d'autres éléments, pour réaliser un routage entre au moins un plot de connexion et des bus.

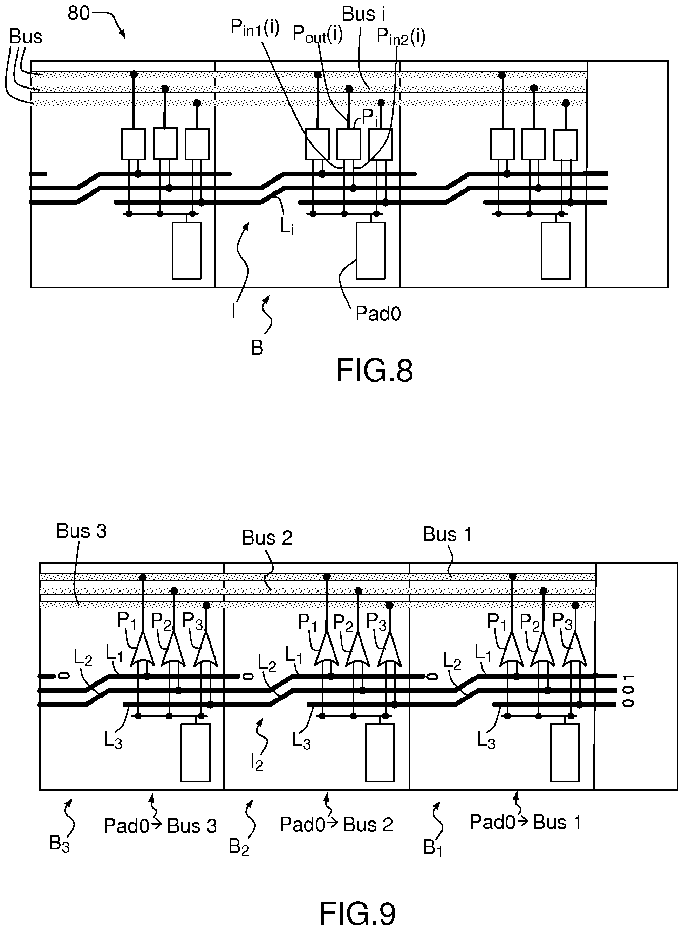

La figure 8 illustre la topologie d'un circuit intégré selon l'invention. Chaque bloc B du circuit intégré 80 comprend en outre au moins un plot de connexion (« pad » en terminologie anglo-saxonne) Pad0, N portes logiques Pi indicé i, chaque porte logique comprenant une première entrée Pin1(i), une deuxième entrée Pin2(i) et une sortie Pout(i) et N bus comprenant chacun une ligne parcourant l'ensemble des N blocs, chaque bus étant relié à la sortie Pout(i) d'une porte logique unique Pi.
Un bus est une ligne conductrice qui traverse l'ensemble des blocs B, destinée à véhiculer des signaux électriques jusqu'à d'autres circuits du bloc B, par exemple des circuits de commande de lignes ou de colonnes. Selon cet aspect de l'invention, le couplage du plot de connexion Pad0 aux bus est réalisé via le circuit d'identification I et les portes logiques Pi de la manière suivante :
- l'ensemble des premières entrées Pin1(i) des portes logiques Pi sont reliées au plot de connexion Pad0,
- chaque deuxième entrée Pin2(i) d'une porte logique Pi est reliée à une ligne de routage Li unique du circuit d'identification I.

Un avantage du circuit intégré selon l'invention est que l'identification s'effectue sans utiliser de composant actif, aucun codage ni décodage n'est nécessaire pour distinguer les blocs. En outre, l'identification reste efficace quelque soit le nombre de blocs.
D'autres avantages de l'invention sont décrits plus loin.

La figure 4 illustre un mode de fonctionnement du circuit d'identification Ij d'un bloc Bj pour distinguer le bloc indicé j. L'identification s'effectue à partir du bloc B1 indicé 1 situé à une extrémité de la pluralité de blocs adjacents. Le circuit d'identification I1 du premier bloc B1 présente donc des entrées qui ne sont pas reliées à un bloc précédent puisqu'il constitue le premier maillon de la chaîne de blocs. Le circuit I1 est tel que la première entrée 1 E1(1) reçoit un niveau logique « 1 », et les entrées i(Ei(1) pour i =2 à N reçoivent un niveau logique « 0 ». On initialise ainsi la chaîne de blocs.
En outre la première sortie 1 S1 du circuit d'identification de chaque bloc (donc pout tout j), qui n'est reliée à aucune entrée du bloc comme décrit précédemment, reçoit un niveau logique « 0 ».
On entend par niveau logique « 0 » un premier état donné, correspondant par exemple à l'application d'une tension de 0V. On entend par niveau logique « 1 » un deuxième état donné, par exemple l'application d'une tension non nulle.
Du fait de la topologie décalée des lignes de routage, la ligne unique présentant la tension « 1 », initialisée à la ligne L1 pour le bloc B1, se décale d'un cran à chaque bloc jusqu'à correspondre à la ligne LN pour le bloc N. Par exemple le bloc D initialise la ligne L1 du premier bloc B1 au niveau logique « 1 », et chaque bloc B initialise cette ligne L1 au niveau logique « 0 ».
Le décalage permet de distinguer les blocs. Les autres entrées étant à « 0 », il suffit de détecter quelle est la ligne de routage, unique, parmi les N lignes de routage L1 ... LN d'un bloc, qui présente le niveau « 1 », pour distinguer le bloc. En d'autres termes, la suite ordonnée Aj des niveaux logiques des entrées de chaque circuit d'identification Ij d'un bloc Bj constitue ainsi un identifiant unique du bloc, soit une adresse de ce bloc.
La figure 4 illustre le principe pour N=3. L'adresse du bloc B1 et '001', l'adresse du bloc B2 est '010' et l'adresse du bloc B3 est '100'.

Selon un mode de réalisation illustré figure 5, le circuit intégré selon l'invention comprend un circuit de lecture Rj associé à chaque circuit d'identification Ij configuré pour prélever le niveau logique de chaque entrée Ei(j), c'est à dire de chaque ligne de routage Li, du circuit d'identification Ij.

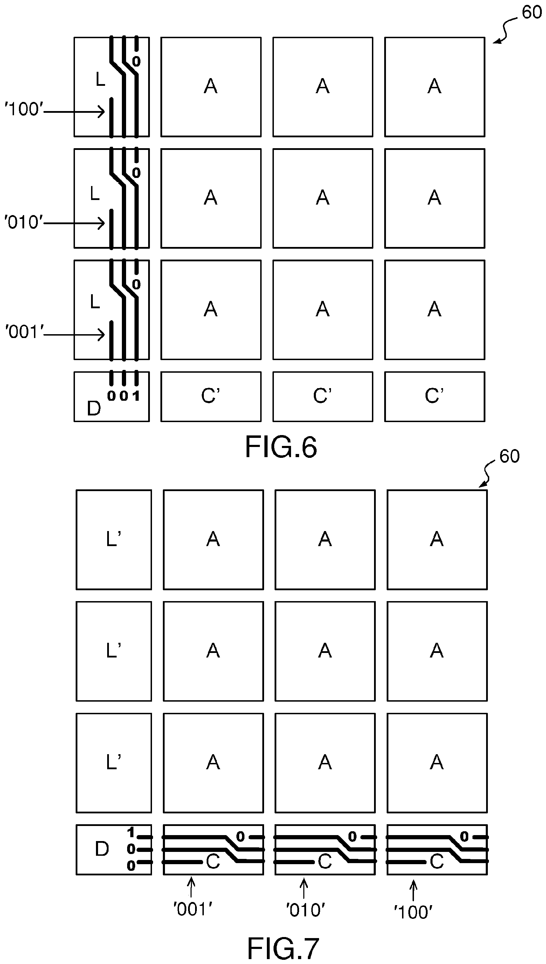

Selon un mode de réalisation illustré figure 6 le circuit d'identification est associé à des blocs identiques de type L' tel que décrit sur la figure 1, comprenant au moins un circuit de commande ligne (driver ligne) destiné à être associé à un circuit matriciel 60 de blocs de type A, un circuit de commande ligne étant configuré par exemple pour traiter une pluralité de signaux injectés dans une pluralité de lignes. Les 3 blocs de type L' selon l'invention, dénommés blocs L, sont ainsi distingués à l'aide de circuits d'identification comprenant 3 lignes de routage.

Selon un autre mode de réalisation illustré figure 7 le circuit d'identification est associé à des blocs identiques de type C' tel que décrit sur la figure 1, comprenant au moins un circuit de commande colonne (driver colonne) destiné à être associé à un circuit matriciel 60 de blocs de type A, un circuit de commande colonne étant configuré par exemple pour traiter une pluralité de signaux provenant d'une pluralité de colonnes. Les 3 blocs de type C' selon l'invention, dénommés blocs C, sont ainsi distinguées à l'aide de circuits d'identification comprenant 3 lignes de routage.

Bien entendu les deux modes de réalisation peuvent être combinés.

Un exemple de fonctionnement du circuit 80 selon l'invention est illustré figure 9.
Dans cet exemple, comme dans l'exemple de fonctionnement précédent décrit figure 4, le routage est initialisé à partir du bloc 1 B1 situé à une extrémité de la pluralité de blocs adjacents Bj. Le circuit d'identification I1 de B1 présente une première entrée E1(1) qui reçoit un niveau logique « 1 » et les entrées i Ei(1) pour i =2 à N reçoivent un niveau logique « 0 ».
Pour chaque bloc Bj, la première sortie 1 S1 du circuit d'identification Ij, qui n'est reliée à aucune entrée du bloc, reçoit un niveau logique « 0 ».
En outre dans cet exemple les N portes logiques sont des portes de type « ou ».
L'indice des bus j est arbitraire, on choisi de les indicer par j par convention et pour simplifier l'explication. Ce qui est important est le nombre N. Dans le circuit intégré selon l'invention on a N blocs adjacents topologiquement identiques par nature, chaque bloc comprenant un circuit d'identification comprenant N lignes de routage L, et N portes logiques P connectées à N bus.
La circulation de la tension « 1 » d'un bloc à l'autre sur les lignes de routage permet de connecter via la porte « ou » reliée à la ligne de routage à « 1 », le plot de connexion pad0 d'un bloc avec un bus unique parmi les N bus, en fonction de la position j du bloc Bj dans la chaine de blocs identiques. Ainsi le circuit d'identification Ij d'un bloc indicé j Bj réalise une fonction de routage reliant le plot de connexion pad0 à un bus unique indicé j Busj.
Sur l'exemple de la figure 9 avec N=3, le bloc B1 opère la connexion de pad0 avec Bus1 via P1, le bloc B2 opère la connexion de pad0 avec Bus2 via P2, le bloc B3 opère la connexion de pad0 avec Bus3 via P3.

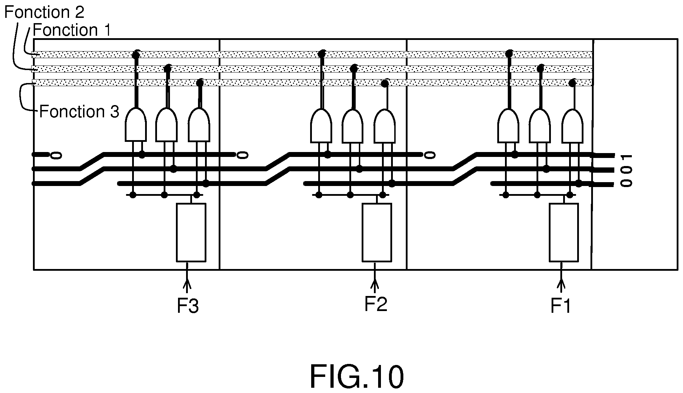

Un avantage de l'invention par rapport à l'état de la technique apparaît sur la figure 10, qui schématise l'architecture de distribution de fonctions selon l'invention, en comparaison avec la figure 2. Du fait de la distinction des blocs réalisant le routage opéré par le circuit selon l'invention, un seul plot de connexion pad0 est suffisant pour distribuer 3 fonctions F1, F2 et F3 sur les bus associés. Il suffit pour cela d'injecter dans le « pad » la fonction associée au bus avec lequel le « pad » est connecté. On affecte donc une fonction particulière à un plot de connexion d'un bloc B indicé j grâce à la ligne de routage reliée à « 1 ». En résumé la distinction des différents blocs permet l'injection de fonctions différentes malgré un motif de masquage identique.
Ainsi un avantage du circuit selon l'invention est de réduire de manière significative le nombre de plots de connexions. Dans l'exemple avec N=3, seulement 3 plots sont nécessaires au lieu de 9 selon l'état de l'art.

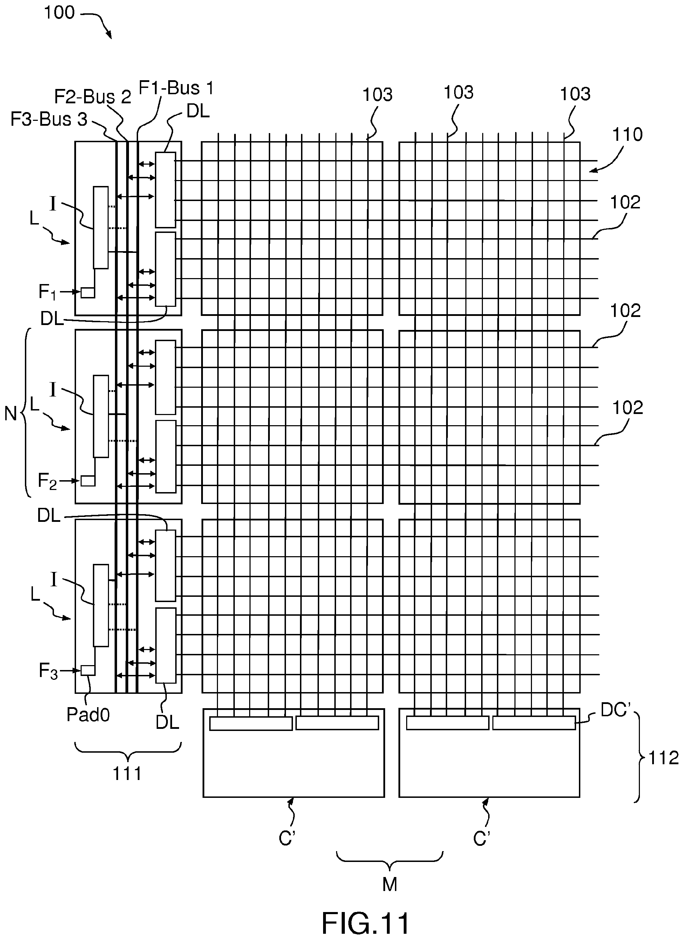

Comme explicité plus haut, les fonctions sont destinées à être partagées par plusieurs circuits.
Selon une variante illustrée figure 11 chacun des N blocs identiques du circuit intégré 111 selon l'invention, dénommé bloc ligne L selon l'invention, comprennent au moins un circuit de commande ligne DL destiné à être associé à un circuit matriciel 110 comprenant des lignes 102 et des colonnes 103, un circuit de commande ligne DL étant configuré pour traiter une pluralité de signaux injectés dans une pluralité de lignes ou provenant d'une pluralité de lignes.
Selon une autre variante chacun des N blocs identiques du circuit intégré selon l'invention, dénommé bloc colonne C selon l'invention, comprennent au moins un circuit de commande colonne DC destiné à être associé à un circuit matriciel 110 comprenant des lignes 102 et des colonnes 103, un circuit de commande colonne DC étant configuré pour traiter une pluralité de signaux injectés dans une pluralité de colonnes ou provenant d'une pluralité de colonnes.

Ainsi pour les deux variantes ci-dessus, le circuit intégré selon l'invention comprend au moins un plot de connexion pad0 associé à N fonctions génériques indicée i Fi, ces fonctions génériques étant distribuées vers l'ensemble des circuits de commande DL (ou DC) des N blocs identiques. Chaque bus Busi est apte à transmettre une fonction générique associée Fi au circuit de commande DL (ou DC) du bloc, et une fonction générique Fi est injectée au « pad » de connexion du bloc réalisant la liaison du « pad » de connexion au bus Busi associé à la fonction générique Fi.
Chaque bloc ligne ou colonne comprend au moins un circuit « driver », et peut bien entendu en comprendre plusieurs.

Le principe est généralisable à une pluralité de plots de connexions par bloc, chaque plot étant associé à N fonctions. Par exemple si on a besoin de 6 fonctions, pour 3 blocs, chaque bloc B selon l'invention comprend 2 plots pad0 et pad1 pour générer les 6 fonctions.
Dans ce cas il y 6 bus de fonction, chaque bus distribuant 1 fonction. Les deux plots utilisent le même circuit identificateur et chaque plot 3 portes logiques associées, ce qui permet d'avoir 2 fois 3 égale 6 fonctions différentes.

Selon un autre aspect également illustré figure 11, l'invention concerne un ensemble intégré 100 comprenant :
- un circuit intégré 111 selon l'invention comprenant N blocs lignes L,
- un circuit matriciel 110,
- un circuit intégré 112 comprenant M blocs identiques C', chaque bloc C' comprenant au moins un circuit de commande de colonne DC', mais ne comprenant pas de circuit d'identification selon l'invention.
Sur la figure 11, N=3 et M=2.

Alternativement, l'ensemble intégré comprend :
- un circuit intégré selon l'invention comprenant N blocs colonne C,
- un circuit matriciel 110,
- un circuit intégré comprenant M blocs identiques L', chaque bloc L' comprenant au moins un circuit de commande de ligne DL', mais ne comprenant pas de circuit d'identification selon l'invention.

Le circuit matriciel 110 peut être réalisé à partir d'un bloc A répété N x M fois.

Bien entendu, alternativement, l'ensemble intégré peut comprendre à la fois des blocs lignes et des blocs colonne selon l'invention. Il comprend alors :
- un circuit intégré selon l'invention comprenant N blocs lignes L,
- un circuit intégré selon l'invention comprenant M blocs colonne C.
- un circuit matriciel 110.

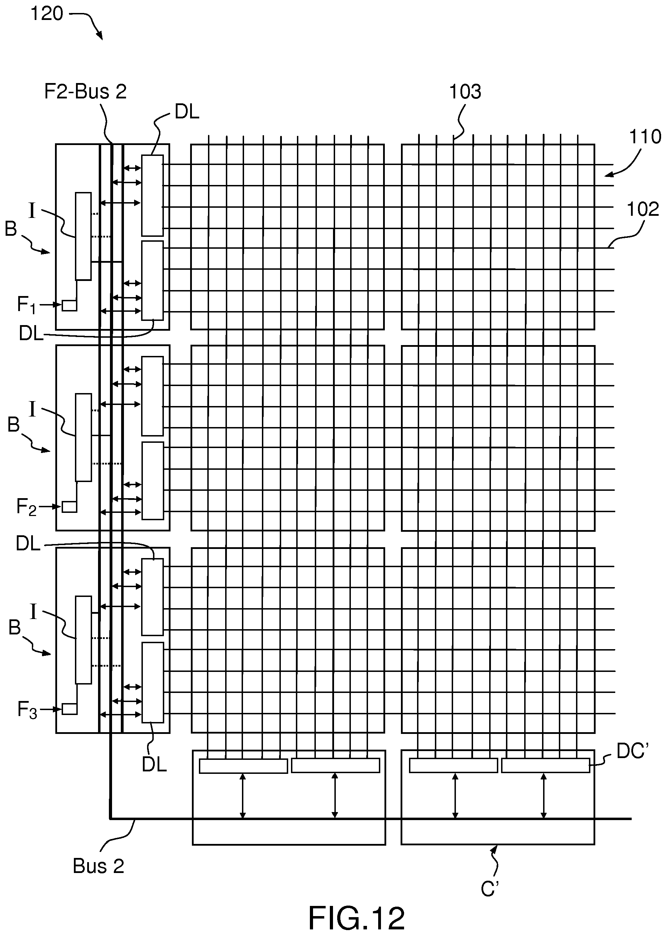

Selon une autre variante illustrée figure 12, l'ensemble intégré 120 comprend au moins un bus, associé à une fonction générique, qui distribue la fonction générique aux circuits de commandes (DC', DL') des M blocs identiques qui ne comprennent pas de circuit d'identification selon l'invention.
Sur l'exemple de la figure 12, la fonction F2, distribuée aux « drivers » lignes par le Bus2 via un circuit selon l'invention, est également distribuée par bus2 aux « drivers » colonnes DC'. Le bus (Bus2 dans l'exemple) parcours alors tous les blocs comprenant des« drivers » lignes et tous les blocs comprenant des « drivers » colonne, et s'étend donc sur deux côtés du circuit matriciel 110. Bus 2 distribue ainsi la fonction 2 à l'ensemble des circuits de commande, lignes (DL) et colonnes (DL').

Des fonctions génériques F1, F2, F3 selon l'invention sont par exemple les fonctions : « chip select » ; « power down » ; « reset ». Ces fonctions sont classiques.

La fonction « chip select » correspond à une sélection du circuit, la fonction « power down » correspond à une mise en faible consommation du circuit, et la fonction « reset » correspond à une remise à zéro du circuit.
Par exemple N=3 et les trois fonctions distribuées sont « chip select », « power down » et « reset ».

Nous allons à présent décrire un exemple d'implémentation d'un ensemble intégré selon l'invention.
L'ensemble intégré selon l'invention constitue par exemple à un détecteur de rayonnement, le circuit matriciel comprenant des pixels (points photosensibles) aux intersections des lignes et des colonnes, destinés à convertir le rayonnement auquel ils sont soumis en signal électrique. Le signal électrique peut prendre la forme d'une charge, d'une tension ou d'un courant. Ces signaux électriques issus des différents pixels sont collectés lors d'une phase de lecture de la matrice puis numérisés de manière à pouvoir être traités et stockés pour former une image.
Par exemple, les pixels sont formés d'une zone photosensible délivrant un courant de charges électriques en fonction du flux de photons quelle reçoit, et d'un circuit électronique de traitement de ce courant. La zone photosensible comprend généralement un élément photosensible, ou photodétecteur, qui peut par exemple être une photodiode, une photorésistance ou un phototransistor. On trouve des matrices photosensibles de grandes dimensions qui peuvent posséder plusieurs millions de pixels.
Le détecteur de rayonnement peut être utilisé pour l'imagerie de rayonnements ionisants, et notamment les rayonnements X ou y, dans le domaine médical ou celui du contrôle non destructif dans le domaine industriel, pour la détection d'images radiologiques. Les éléments photosensibles permettent de détecter un rayonnement électromagnétique visible ou proche du visible. Ces éléments ne sont pas, ou peu, sensibles au rayonnement incident au détecteur. On utilise alors fréquemment un convertisseur de rayonnement appelé scintillateur qui convertit le rayonnement incident, par exemple un rayonnement X, en un rayonnement dans une bande de longueurs d'onde auxquelles sont sensibles les éléments photosensibles présents dans les pixels.

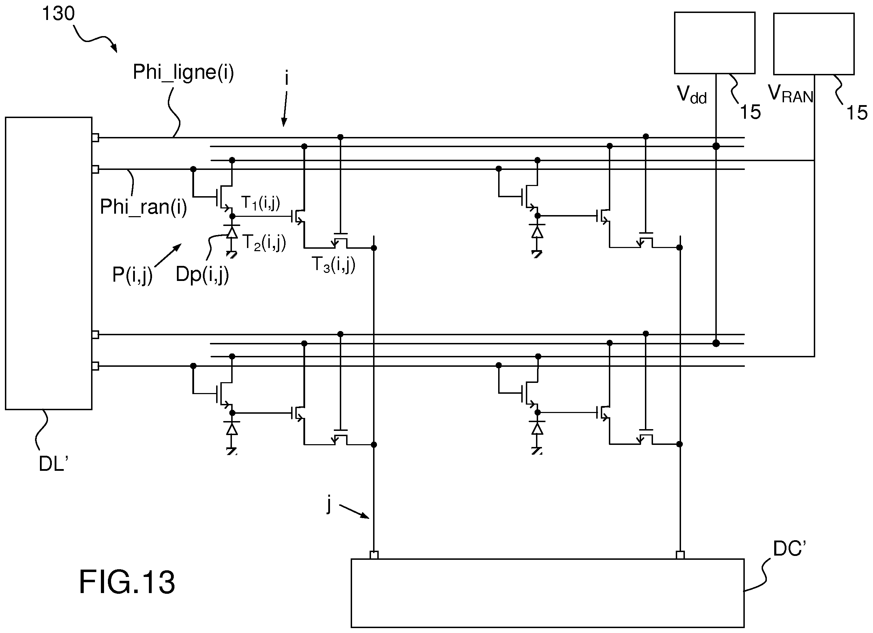

La figure 13 schématise 4 pixels d'un capteur d'image CMOS 130, les pixels étant couramment dénommés 3T. Une ligne est indicée i et une colonne j, le pixel à l'intersection de la ligne i et de la colonne j est P(i, j).
Chaque pixel comprend une zone photosensible représenté ici par une photodiode D et un circuit électronique de traitement formé de trois transistors T1, T2 et T3. Sur la figure, les repères de la photodiode D et des trois transistors sont suivi de deux coordonnées (i,j) pouvant prendre le rang de la ligne pour i et le rang de la colonne pour j. Les pixels d'une même ligne sont raccordés à quatre conducteurs véhiculant des signaux Phi_ligne, Vdd, V_ran et Phi_ran permettant de commander chacune des lignes de pixels. Phi_ligne et phi_ran sont gérés par le circuit de commande de ligne DL' (également dénommé circuit d'adressage ligne), Vdd et V_ran sont des tensions de polarisation. Le fonctionnement bien connu de ce détecteur n'est pas détaillé ici.

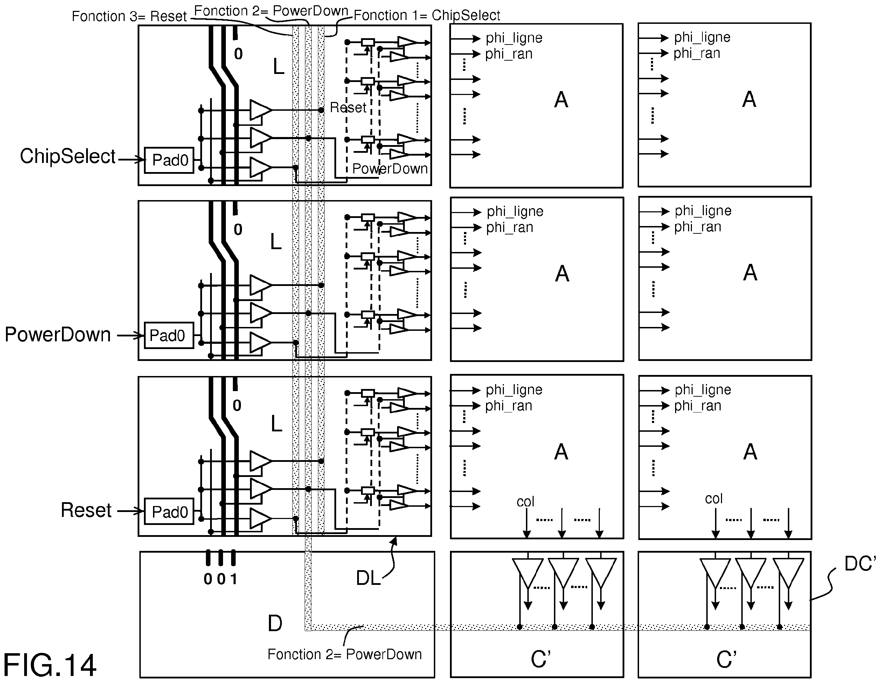

La figure 14 illustre un exemple d'implémentation de l'invention à ce type de détecteur. Le bloc ligne L selon l'invention permet la distribution des trois fonctions « chip select », « power down » et « reset » aux circuits de commande de ligne DL via un seul plot de connexion pad0. La fonction power down est partagée avec les circuits de commande de colonne DC' des blocs C' ne comprenant pas l'invention.
Dans cet exemple chaque plot pad0 commande 3 « buffers » dont la sortie est en haute impédance, sauf si son entrée sur le côté est à « 1 ». Du fait que seule une ligne est à « 1 » par bloc L, le plot « pad0 » présente une seule fonction par bloc : « ChipSelect » ou « PowerDown » ou « Reset ». La fonction « Reset » et son signal associé met alors à zéro toutes les bascules de tous les blocs L. La fonction « PowerDown » et son signal associé met alors en mode faible consommation tous les amplificateurs de tous les blocs L et également de tous les blocs C'.

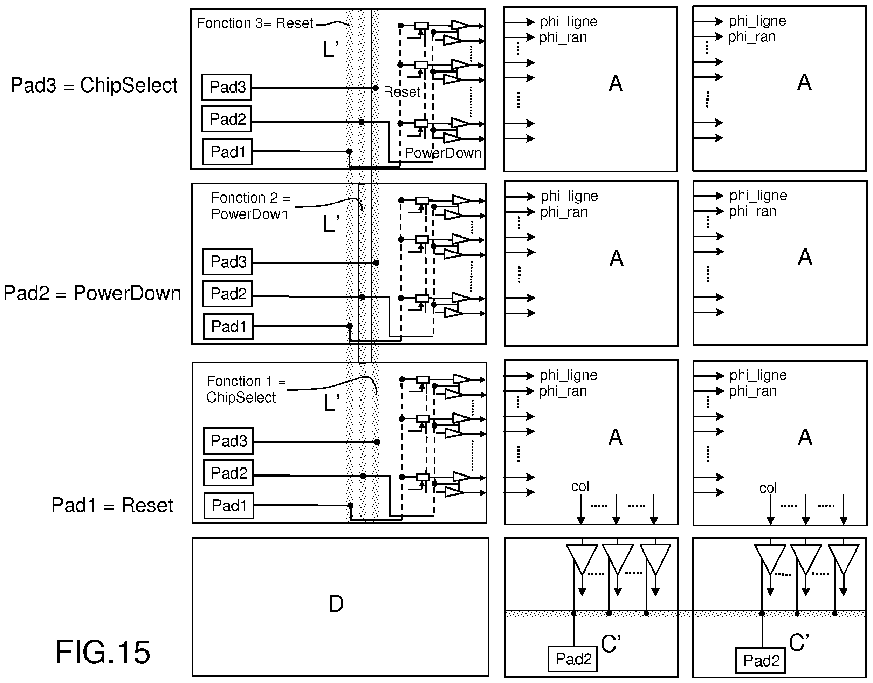

La figure 15 illustre un détecteur selon l'état de la technique comprenant trois plots de connexion par bloc pour comparaison.

Selon un autre mode de réalisation, l'ensemble intégré selon l'invention constitue un circuit mémoire, le circuit matriciel comprenant des points mémoires destinés à mémoriser une information. Les circuits mémoires sont des circuits pour lesquels on cherche à atteindre une taille maximum. Ils incluent les mêmes fonctions d'amplification ou de sélection. Ainsi la même technique permet de réduire le nombre de plots du circuit en gardant les mêmes fonctions.

## Revendications

1. Circuit intégré (10, 80) comprenant une pluralité de N blocs identiques adjacents indicés par un indice j, un bloc courant (Bj) étant relié à un bloc précédent (Bj-1) et à un bloc suivant (Bj+1), chaque bloc comprenant un circuit d'identification (Ij) comprenant :
- N entrées ordonnées indicées i (Ei(j)), connectées aux N sorties du bloc précédent (Bj-1) de même indice, et
- N sorties ordonnées indicées i (Si(j)), connectées aux N entrées du bloc suivant (Bj+1) de même indice et ,
- chaque entrée i (Ei(j)) pour i ≠N du bloc courant (Bj) est reliée par une ligne de routage indicée i (Li) à la sortie i+1 (Si+1 (j)) du bloc courant
- une dernière entrée N (EN(j)) du bloc courant (Bj) n'est reliée à aucune sortie dudit bloc courant,
- une première sortie 1 (S1(j)) du bloc courant (Bj) n'est reliée à aucune entrée dudit bloc courant,
chaque bloc (B) comprenant en outre :
- au moins un plot de connexion (Pad0) et,
- N portes logiques indicé i (Pi), chaque porte logique (Pi) comprenant une première entrée (Pin1(i)), une deuxième entrée (Pin2(i)) et une sortie (Pout(i)),
- N bus indicé i comprenant chacun une ligne parcourant l'ensemble des N blocs, chaque bus étant relié à la sortie (Pout(i)) d'une porte logique unique (Pi),
le couplage du plot de connexion aux bus étant réalisé via le circuit d'identification et les portes logiques de manière que :
- l'ensemble des premières entrées (Pin1(i)) des portes logiques (Pi) étant reliées au plot de connexion,
- chaque deuxième entrée (Pin2(i)) d'une porte logique (Pi) étant reliée à une ligne de routage (Li) unique du circuit d'identification (I).

2. Circuit intégré selon la revendication 1, dans lequel :
- le circuit d'identification (11) du premier bloc (B1) situé à une extrémité de la pluralité de blocs adjacents est tel que :
- la première entrée 1 (E1 (1)) reçoit un niveau logique « 1 »,
- les entrées i (Ei(1)) pour i =2 à N reçoivent un niveau logique « 0 »,
- la première sortie 1 (S1) du circuit d'identification de chaque bloc, qui n'est reliée à aucune entrée du bloc, reçoit un niveau logique « 0 »,
de sorte que la suite ordonnée (Aj) des niveaux logiques des entrées de chaque circuit d'identification (Ij) d'un bloc (Bj) constitue un identifiant unique du bloc.

3. Circuit intégré selon la revendication 2, dans lequel la suite ordonnée (Aj) des niveaux logiques des entrées d'un circuit d'identification (Ij) d'un bloc (Bj) constitue une adresse du bloc (Bj).

4. Circuit intégré selon l'une des revendications 2 ou 3, comprenant en outre un circuit de lecture (Rj) associé à chaque circuit d'identification (Ij) configuré pour prélever le niveau logique de chaque entrée (Ei(j)) du circuit d'identification (Ij).

5. Circuit intégré selon l'une des revendications précédentes , dans lequel :
- le circuit d'identification (11) du premier bloc (B1) situé à une extrémité de la pluralité de blocs adjacents présentant une première entrée (E1 (1)) non reliée à un bloc précédent est tel que :
- les entrées i pour i =2 à N (Ei(1)) reçoivent un niveau logique « 0 »,
- la première entrée 1 (E1 (j)) reçoit un niveau logique « 1 »,
- la première sortie 1 (S1) du circuit d'identification (I) de chaque bloc (B) qui n'est reliée à aucune entrée du bloc reçoit un niveau logique « 0 »,
- les N portes logiques sont des portes de type « ou » de sorte que le circuit d'identification (Ij) d'un bloc indicé j (Bj) réalise une fonction de routage reliant le plot de connexion (pad0) à un bus unique indicé j (Busj).

6. Circuit intégré selon la revendication 5, dans lequel les N blocs identiques, dénommés bloc ligne, comprennent en outre chacun au moins un circuit de commande ligne (DL) destiné à être associé à un circuit matriciel (110) comprenant des lignes (102) et des colonnes (103), un circuit de commande ligne (DL) étant configuré pour traiter une pluralité de signaux injectés dans une pluralité de lignes ou provenant d'une pluralité de lignes.

7. Circuit intégré selon la revendication 5, dans lequel les N blocs identiques, dénommés bloc colonne, comprennent en outre chacun au moins un circuit de commande colonne (DC) destiné à être associé à un circuit matriciel (110) comprenant des lignes (102) et des colonnes (103), un circuit de commande colonne (DC) étant configuré pour traiter une pluralité de signaux injectés dans une pluralité de colonnes ou provenant d'une pluralité de colonnes.

8. Circuit intégré selon l'une des revendications 6 ou 7, dans lequel un pad de connexion (pad0) est associé à N fonctions génériques indicée i (Fi), lesdites fonctions génériques étant distribuées vers l'ensemble des circuits de commande des N blocs identiques,
- chaque bus (Busi) étant apte à transmettre une fonction générique associée (Fi) au circuit de commande du bloc,
- une fonction générique (Fi) étant injectée au pad de connexion du bloc réalisant la liaison du pad de connexion au bus (Busi) associé à la fonction générique (Fi).

9. Circuit intégré selon la revendication 8, comprenant une pluralité de plots de connexion, chaque plot de connexion étant associé à N fonctions génériques.

10. Circuit intégré selon l'une des revendications 8 ou 9, dans lequel des fonctions génériques (F1, F2, F3) sont choisies parmi les fonctions « chip select » et/ou « power down » et/ou « reset ».

11. Ensemble intégré (100) comprenant un circuit intégré selon l'une des revendications 6 à 10, un circuit matriciel (110) et une pluralité de M blocs identiques (C', L') comprenant au moins un circuit de commande (DC', DL').

12. Ensemble intégré (120) selon la revendication 11 dans lequel au moins un bus associé à une fonction générique distribue ladite fonction générique aux circuits de commandes (DC', DL') des M blocs identiques.

13. Ensemble intégré selon l'une des revendications 11 ou 12 constituant un détecteur de rayonnement, le circuit matriciel comprenant des pixels destinés à convertir un rayonnement en signal électrique.

14. Ensemble intégré selon l'une des revendications 11 ou 12 constituant un circuit mémoire, le circuit matriciel comprenant des points mémoires destinés à mémoriser une information.

## Patentansprüche

1. Integrierte Schaltung (10, 80), umfassend eine Vielzahl von N identischen benachbarten Blöcken indiziert durch einen Index j, wobei ein aktueller Block (Bj) mit einem vorherigen Block (Bj-1) und einem nachfolgenden Block (Bj+1) verbunden ist, jeder Block umfassend eine Identifizierungsschaltung (Ij), umfassend:
- N geordnete Eingänge mit Index i (Ei(j)), verbunden mit den N Ausgängen des vorherigen Blocks (Bj-1) mit dem gleichen Index, und
- N geordnete Ausgänge mit dem Index i (Si(j)), verbunden mit den N Eingängen des nachfolgenden Blocks (Bj+1) mit dem gleichen Index, und
- wobei jeder Eingang i (Ei(j)) für i ≠ N des aktuellen Blocks (Bj) durch eine Weiterleitungsleitung mit Index i (Li) mit dem Ausgang i+1 (Si+1 (j)) des aktuellen Blocks verbunden ist,
- ein letzter Eingang N (EN(j)) des aktuellen Blocks (Bj) mit keinem Ausgang des aktuellen Blocks verbunden ist,
- ein erster Ausgang 1 (S1(j)) des aktuellen Blocks (Bj) mit keinem Eingang des aktuellen Blocks verbunden ist,
jeder Block (B) ferner umfassend:
- mindestens eine Verbindungsstelle (Pad0), und
- N logische Gatter mit Index i (Pi), jedes logische Gatter (Pi) umfassend einen ersten Eingang (Pin1(i)), einen zweiten Eingang (Pin2(i)) und einen Ausgang (Pout(i)),
- N Busse mit Index i, jeweils umfassend eine Leitung, die sämtliche N Blöcke durchläuft, wobei jeder Bus mit dem Ausgang (Pout(i)) von einem einmaligen logischen Gatter (Pi) verbunden ist,
wobei die Kopplung der Verbindungsstelle mit dem Bus über die Identifizierungsschaltung und die logischen Gatter so durchgeführt wird, dass:
- sämtliche erste Eingänge (Pin1(i)) der logischen Gatter (Pi) mit der Verbindungsstelle verbunden sind,
- jeder zweite Eingang (Pin2(i)) eines logischen Gatters (Pi) mit einer einmaligen Weiterleitungsleitung (Li) der Identifizierungsschaltung (I) verbunden ist.

2. Integrierte Schaltung nach Anspruch 1, wobei:
- die Identifizierungsschaltung (I1) des ersten Blocks (B1), die sich an einem Ende der Vielzahl von benachbarten Blöcke befindet, derart ist, dass:
- der erste Eingang 1 (E1(1)) ein logisches Niveau "1" erhält,
- die Eingänge i (Ei(1)) für i = 2 bis N ein logisches Niveau "0" erhalten,
- der erste Ausgang 1 (S1) der Identifizierungsschaltung von jedem Block, der mit keinem Eingang des Blocks verbunden ist, ein logisches Niveau "0" erhält,
sodass die geordnete Abfolge (Aj) der logischen Niveaus der Eingänge von jeder Identifizierungsschaltung (Ij) eines Blocks (Bj) eine einmalige Kennung des Blocks bildet.

3. Integrierte Schaltung nach Anspruch 2, wobei die geordnete Abfolge (Aj) der logischen Niveaus der Eingänge einer Identifizierungsschaltung (Ij) eines Blocks (Bj) eine Adresse des Blocks (Bj) bildet.

4. Integrierte Schaltung nach einem der Ansprüche 2 oder 3, ferner umfassend eine Leseschaltung (Rj), die mit jeder Identifizierungsschaltung (Ij) assoziiert ist, die konfiguriert ist, um das logische Niveau von jedem Eingang (Ei(j)) der Identifizierungsschaltung (Ij) zu entnehmen.

5. Integrierte Schaltung nach einem der vorherigen Ansprüche, wobei:
- die Identifizierungsschaltung (I1) des ersten Blocks (B1), die sich an einem Ende der Vielzahl von benachbarten Blöcke befindet, die einen ersten Eingang (E1(1)) aufweisen, der nicht mit einem vorherigen Block verbunden ist, derart ist, dass:
- die Eingänge i für i =2 bis N (Ei(1)) ein logisches Niveau "0" erhalten,
- der erste Eingang 1 (E1(j)) ein logisches Niveau "1" erhält,
- der erste Ausgang 1 (S1) der Identifizierungsschaltung (I) von jedem Block (B), der mit keinem Eingang des Blocks verbunden ist, ein logisches Niveau "0" erhält,
- die N logischen Gatter Gatter vom Typ "oder" sind, sodass die Identifizierungsschaltung (Ij) eines Blocks mit Index j (Bj) eine Weiterleitungsfunktion durchführt, die die Verbindungsstelle (pad0) mit einem einmaligen Bus mit Index j (Busj) verbindet.

6. Integrierte Schaltung nach Anspruch 5, wobei die N identischen Blöcke, bezeichnet als Zeilenblock, ferner jeweils mindestens einen Zeilensteuerkreis (DL) umfassen, der dazu bestimmt ist, mit einer Matrixschaltung (110) assoziiert zu werden, die Zeilen (102) und Spalten (103) umfasst, wobei ein Zeilensteuerkreis (DL) konfiguriert ist, um eine Vielzahl von Signalen, die in eine Vielzahl von Zeilen eingespeist werden oder von einer Vielzahl von Zeilen stammen, zu behandeln.

7. Integrierte Schaltung nach Anspruch 5, wobei die N identischen Blöcke, bezeichnet als Spaltenblock, ferner jeweils mindestens ein Spaltensteuerkreis (DC) umfassen, der dazu bestimmt ist, mit einer Matrixschaltung (110) assoziiert zu werden, die Zeilen (102) und Spalten (103) umfasst, wobei ein Spaltensteuerkreis (DC) konfiguriert ist, um eine Vielzahl von Signalen, die in eine Vielzahl von Spalten eingespeist werden oder von einer Vielzahl von Spalten stammen, zu behandeln.

8. Integrierte Schaltung nach einem der Ansprüche 6 oder 7, wobei eine Verbindungsstelle (pad0) mit N generischen Funktionen mit Index i (Fi) assoziiert ist, wobei die generischen Funktionen zu allen Steuerkreisen der N identischen Blöcke verteilt werden,
- wobei jeder Bus (Busi) geeignet ist, eine assoziierte generische Funktion (Fi) an den Steuerkreis des Blocks zu übermitteln,
- wobei eine generische Funktion (Fi) in die Verbindungsstelle des Blocks eingespeist wird, die die Verbindung der Verbindungsstelle mit dem Bus (Busi) durchführt, der mit der generischen Funktion (Fi) assoziiert ist.

9. Integrierte Schaltung nach Anspruch 8, umfassend eine Vielzahl von Verbindungsstellen, wobei jede Verbindungsstelle mit N generischen Funktionen assoziiert ist.

10. Integrierte Schaltung nach einem der Ansprüche 8 oder 9, wobei die generischen Funktionen (F1, F2, F3) ausgewählt sind unter den Funktionen "chip select" und/oder "power down" und/oder "reset".

11. Integrierte Baugruppe (100), umfassend eine integrierte Schaltung nach einem der Ansprüche 6 bis 10, wobei eine Matrixschaltung (110) und eine Vielzahl von M identischen Blöcken (C', L') mindestens einen Steuerkreis (DC', DL') umfassen.

12. Integrierte Baugruppe (120) nach Anspruch 11, wobei mindestens ein Bus, der mit einer generischen Funktion assoziiert ist, die generische Funktion an die Steuerkreise (DC', DL') der M identischen Blöcke verteilt.

13. Integrierte Baugruppe nach einem der Ansprüche 11 oder 12, die einen Strahlungsdetektor bildet, wobei die Matrixschaltung Pixel umfasst, die dazu bestimmt sind, eine Strahlung in ein elektrisches Signal zu umwandeln.

14. Integrierte Baugruppe nach einem der Ansprüche 11 oder 12, die einen Speicherschaltkreis bildet, wobei die Matrixschaltung Speicherpunkte umfasst, die dazu bestimmt sind, eine Information zu speichern.

## Claims

1. Integrated circuit (10, 80) comprising a plurality of N identical adjacent blocks which are indexed by an index j, a current block (Bj) being connected to a preceding block (Bj-1) and a subsequent block (Bj+1), each block comprising an identification circuit (Ij) comprising:
- N ordered inputs indexed i (Ei(j)), connected to the N outputs of the preceding block (Bj-1) having the same index, and
- N ordered outputs indexed i (Si(j)), connected to the N inputs of the following block (Bj+1) having the same index, and
- wherein each input i (Ei(j)) for in≠N of the current block (Bj) is connected via an routing line indexed i (Li) to the output i+1 (Si+1 (j)) of the current block,
- a last input N (EN(j)) of the current block (Bj) is not connected to any output of the current block,
- a first output 1 (S1(j) of the current block (Bj) is not connected to any input of the current block,
each block (B) further comprising:
- at least one connection pad (Pad0) and,
- N logical ports indexed i (Pi), each logical port (Pi) comprising a first input (Pin1 (i)), a second input (Pin2(i)) and an output (Pout(i)),
- N buses indexed i each comprising a line which extends over all of the N blocks, each bus being connected to the output (Pout(i)) of a single logical port (Pi),
the coupling of the connection pad to the buses being carried out via the identification circuit and the logical ports so that:
- all of the first inputs (Pin1(i)) of the logical ports (Pi) are connected to the connection pad,
- each second input (Pin2(i)) of a logical port (Pi) is connected to a single routing line (Li) of the identification circuit (I).

2. Integrated circuit according to claim 1, wherein:
- the identification circuit (I1) of the first block (B1) located at one end of the plurality of adjacent blocks is such that:
- the first input 1 (E1(1)) receives a logic level "1",
- the inputs i (Ei(1)) for i = 2 to N receive a logic level "0",
- the first output 1 (S1) of the identification circuit of each block which is not connected to any input of the block receives a logic level "0",
so that the ordered sequence (Aj) of the logic levels of the inputs of each identification circuit (Ij) of a block (Bj) constitutes a single identifier of the block.

3. Integrated circuit according to claim 2, wherein the ordered sequence (Aj) of the logic levels of the inputs of an identification circuit (1j) of a block (Bj) constitutes an address of the block (Bj).

4. Integrated circuit according to either claim 2 or 3, further comprising a reading circuit (Rj) which is associated with each identification circuit (Ij) which is configured to retrieve the logic level of each input (Ei(j)) of the identification circuit (1j).

5. Integrated circuit according to any one of the preceding claims, wherein:
- the identification circuit (I1) of the first block (B1) located at one end of the plurality of adjacent blocks having a first input (E1(1)) which is not connected to a preceding block is such that:
- the inputs i for i = 2 to N (Ei(1)) receive a logic level "0",
- the first input 1 (E1(j) receives a logic level "1",
- the first output 1 (S1) of the identification circuit (1) of each block (B) which is not connected to any input of the block receives a logic level "0",
- the N logic ports are ports of the "or" type so that the identification circuit (Ij) of a block indexed j (Bj) carries out a routing function which connects the connection pad (pad0) to a single bus indexed j (Busj).

6. Integrated circuit according to claim 5, wherein the N identical blocks, referred to as a line block, each further comprise at least one line control circuit (DL) which is intended to be associated with a matrix circuit (110) comprising lines (102) and columns (103), a line control circuit (DL) being configured to process a plurality of signals which are injected into a plurality of lines or which originate from a plurality of lines.

7. Integrated circuit according to claim 5, wherein the N identical blocks, referred to as a column block, each further comprise at least one column control circuit (DC) which is intended to be associated with a matrix circuit (110) comprising lines (102) and columns (103), a column control circuit (DC) being configured to process a plurality of signals which are injected into a plurality of columns or which originate from a plurality of columns.

8. Integrated circuit according to either claim 6 or 7, wherein a connection pad (pad0) is associated with N generic functions indexed i (Fi), said generic functions being distributed to all the control circuits of the N identical blocks,
- each bus (Busi) being capable of transmitting an associated generic function (Fi) to the control circuit of the block,
- a generic function (Fi) being injected into the connection pad of the block which carries out the connection of the connection pad to the bus (Busi) associated with the generic function (Fi).

9. Integrated circuit according to claim 8, comprising a plurality of connection pads, each connection pad being associated with N generic functions.

10. Integrated circuit according to either claim 8 or claim 9, wherein generic functions (F1, F2, F3) are selected from the functions "chip select" and/or "power down" and/or "reset".

11. Integrated assembly (100) comprising an integrated circuit according to any one of claims 6 to 10, a matrix circuit (110) and a plurality of M identical blocks (C', L') comprising at least one control circuit (DC', DL').

12. Integrated assembly (120) according to claim 11, wherein at least one bus associated with a generic function distributes said generic function to the control circuits (DC', DL') of the M identical blocks.

13. Integrated assembly according to either claim 11 or 12, constituting a radiation detector, the matrix circuit comprising pixels which are intended to convert radiation into an electrical signal.

14. Integrated assembly according to either claim 11 or 12, constituting a memory circuit, the matrix circuit comprising memory points which are intended to store an item of information.
